# EUROPEAN PATENT APPLICATION

(11) **EP 3 967 786 A1**
(43) Date of publication of application: **16.03.2022**
(21) Application number: 21173583.2
(22) Date of filing: 12.05.2021
(51) Int. Cl.: C23C 14/00, C23C 14/02, C23C 14/06, C23C 14/08, C23C 14/35, C23C 28/00, A01N 25/34

(54) **A COATED SUBSTRATE AND A METHOD FOR FORMING A COATED SUBSTRATE**

(30) Priority: 13.05.2020 US 202063024096 P
(71) Applicant: Vapor Technologies, Inc., Longmont CO 80503 (US)
(72) Inventor: Sullivan, Patrick, Longmont, 80504 (US); Anton, Bryce, Longmont, 80503 (US); Kunrath, Augusto, 80220, Denver (US)
(74) Representative: Beck Greener LLP

(57) **Abstract**

A coated substrate includes a base substrate and a base layer disposed over the substrate. Typically, the base layer is composed of a component selected from the group consisting of zirconium carbonitrides, zirconium oxycarbides, titanium carbonitrides, titanium oxycarbides, and combinations thereof. One or more copper-containing antimicrobial layers are disposed over the base layer such that each of the one or more copper-containing antimicrobial layers includes copper atoms in the +1 oxidation state and/or the +2 oxidation state.

## Description

The present invention relates to a coated substrate and a method for forming a coated substrate. In particular, the present invention relates to antibacterial coatings and, more particularly, to multilayer coatings having antibacterial properties.

Generally, copper and copper alloys with over 60% copper have been shown to have antimicrobial properties. However, copper and copper alloys are relatively soft and prone to oxidation/corrosion. Some research supports the theory that the efficacy of copper alloys against microbes scales with the tendency to corrode. Therefore, it is believed that the tendency to corrode correlates with the effectiveness of killing microbes.

Oxides of copper include cuprous oxide (Cu₂O, cuprite) and cupric oxide (CuO, tenorite). Both are semiconductors and transition metal oxides (TMO), thin films of which have a variety of uses, including electronic devices, catalysts, sensors, and solar cell absorbers. Oxides of copper tend to be more chemically stable and harder than copper metal.

Accordingly, there is a need for antimicrobial coatings with improved corrosion resistance and durability.

In at least one aspect of the present invention, there is provided a coated substrate comprising: a base substrate and a base layer disposed over the base substrate. Typically, the base layer is composed of a component selected from the group consisting of zirconium carbonitrides, zirconium oxycarbides, titanium carbonitrides, titanium oxycarbides, chromium oxide (e.g., Cr₂O₃), chromium nitride, chromium carbonitride, diamond-like carbon, chromium metal, and combinations thereof. One or more copper-containing antimicrobial layers are disposed over the base layer such that each of the one or more copper-containing antimicrobial layers includes copper atoms in the +1 oxidation state and/or the +2 oxidation state. Advantageously, the copper containing antimicrobial layers are found to have improved corrosion resistance and durability. In another aspect of the present invention, there is provided a method for forming the coated substrate set forth herein. The method includes a step of providing a base substrate. A base layer is deposited over the base substrate. The base layer can be composed of a component selected from the group consisting of zirconium carbonitrides, zirconium oxycarbides, titanium carbonitrides, titanium oxycarbides, diamond-like carbon, chromium nitride, chromium carbonitride, chromium metal, and combinations thereof. One or more copper-containing antimicrobial layers are deposited over the base layer. Characteristically, each of the one or more copper-containing antimicrobial layers includes copper atoms in a +1 oxidation state and/or a +2 oxidation state.

Embodiments of the present invention will hereinafter be described by way of examples, with references to the accompanying drawings, in which:
FIGURE 1 is a schematic of a coated substrate having a zirconium or titanium-containing base layer and a single copper-containing antimicrobial layer;
FIGURE 2 is a schematic of a coated substrate having a zirconium or titanium-containing base layer and a plurality of copper-containing antimicrobial layers;
FIGURES 3A and 3B are schematic flowcharts for a method of making the coated substrate of Figures 1 and 2; and
FIGURE 4 is a schematic of a coating apparatus for coating a base substrate with a zirconium or titanium-containing base layer and one or more copper-containing antimicrobial layers.

Reference will now be made in detail to presently preferred compositions, embodiments and methods of the present invention, which constitute the best modes of practicing the invention presently known to the inventors. The Figures are not necessarily to scale. However, it is to be understood that the disclosed embodiments are merely exemplary of the invention that may be embodied in various and alternative forms. Therefore, specific details disclosed herein are not to be interpreted as limiting, but merely as a representative basis for any aspect of the invention and/or as a representative basis for teaching one skilled in the art to variously employ the present invention.

It is also to be understood that this invention is not limited to the specific embodiments and methods described below, as specific components and/or conditions may, of course, vary. Furthermore, the terminology used herein is used only for the purpose of describing particular embodiments of the present invention and is not intended to be limiting in any way.

It must also be noted that, as used in the specification and the appended claims, the singular form "a," "an," and "the" comprise plural referents unless the context clearly indicates otherwise. For example, reference to a component in the singular is intended to comprise a plurality of components.

The term "comprising" is synonymous with "including," "having," "containing," or "characterized by." These terms are inclusive and open-ended and do not exclude additional, unrecited elements or method steps.

The phrase "consisting of' excludes any element, step, or ingredient not specified in the claim. When this phrase appears in a clause of the body of a claim, rather than immediately following the preamble, it limits only the element set forth in that clause; other elements are not excluded from the claim as a whole.

The phrase "consisting essentially of' limits the scope of a claim to the specified materials or steps, plus those that do not materially affect the basic and novel characteristic(s) of the claimed subject matter.

With respect to the terms "comprising," "consisting of," and "consisting essentially of," where one of these three terms is used herein, the presently disclosed and claimed subject matter can include the use of either of the other two terms.

The phrase "composed of' means "including" or "comprising." Typically, this phrase is used to denote that an object is formed from a material.

It should also be appreciated that integer ranges explicitly include all intervening integers. For example, the integer range 1-10 explicitly includes 1, 2, 3, 4, 5, 6, 7, 8, 9, and 10. Similarly, the range 1 to 100 includes 1, 2, 3, 4.... 97, 98, 99, 100. Similarly, when any range is called for, intervening numbers that are increments of the difference between the upper limit and the lower limit divided by 10 can be taken as alternative upper or lower limits. For example, if the range is 1.1 to 2.1 the following numbers 1.2, 1.3, 1.4, 1.5, 1.6, 1.7, 1.8, 1.9, and 2.0 can be selected as lower or upper limits.

In the examples set forth herein, concentrations, temperature, and reaction conditions (e.g., pressure, pH, flow rates, etc.) can be practiced with plus or minus 50 percent of the values indicated rounded to or truncated to two significant figures of the value provided in the examples. In a refinement, concentrations, temperature, and reaction conditions (e.g., pressure, pH, flow rates, etc.) can be practiced with plus or minus 30 percent of the values indicated rounded to or truncated to two significant figures of the value provided in the examples. In another refinement, concentrations, temperature, and reaction conditions (e.g., pressure) can be practiced with plus or minus 10 percent of the values indicated rounded to or truncated to two significant figures of the value provided in the examples.

The term "metal" as used herein means an alkali metal, an alkaline earth metal, a transition metal, a lanthanide, an actinide, or a post-transition metal.

The term "alkali metal" means lithium, sodium, potassium, rubidium, cesium, and francium.

The term "alkaline earth metal" means a chemical element in group 2 of the periodic table. The alkaline earth metals include beryllium, magnesium, calcium, strontium, barium, and radium.

The term "transition metal" means an element whose atom has a partially filled d sub-shell, or which can give rise to cations with an incomplete d sub-shell. Examples of transition metals includes scandium, titanium, vanadium, chromium, manganese, iron, cobalt, nickel, copper, yttrium, zirconium, niobium, molybdenum, technetium, ruthenium, rhodium, palladium, silver, hafnium, tantalum, tungsten, rhenium, osmium, iridium, platinum, and gold.

The term "lanthanide" or lanthanoid series of chemical elements" means an element with atomic numbers 57-71. The lanthanides metals include lanthanum, cerium, praseodymium, samarium, europium, gadolinium neodymium, promethium, terbium, dysprosium, holmium, erbium, thulium, ytterbium, or lutetium.

The term "actinide" or "actinide series of chemical elements" means chemical elements with atomic numbers from 89 to 103. Examples of actinides includes actinium, thorium, protactinium, uranium, neptunium, and plutonium.

The term "post-transition metal" means gallium, indium, tin, thallium, lead, bismuth, zinc, cadmium, mercury, aluminum, germanium, antimony, or polonium.

Throughout this application, where publications are referenced, the disclosures of these publications in their entireties are hereby incorporated by reference into this application to more fully describe the state of the art to which this invention pertains.

### Abbreviations:

"PVD" means physical vapor deposition.

"HIPIMS" means high-power impulse magnetron sputtering.

In one embodiment, a coated substrate that includes a base substrate and a base layer disposed over the base substrate is provided. In this context "base substrate" means the substrate to be coated by the methods herein. Characteristically, the base layer is a zirconium-containing base layer and/or a titanium-containing base layer. In a refinement, the base layer is composed of a component selected from the group consisting of zirconium carbonitrides, zirconium oxycarbides, titanium carbonitrides, titanium oxycarbides, and combinations thereof. One or more (i.e., or a plurality of) copper-containing antimicrobial layers are disposed over the base layer such that each of the one or more copper-containing antimicrobial layers includes copper atoms in the +1 oxidation state and/or the +2 oxidation state. In a refinement, copper-containing antimicrobial layers contact the base layer (i.e., one of the one or more copper-containing antimicrobial layers contact the base layer). The one or more copper-containing antimicrobial layers can be the same (e.g., composed of the same material) or different (e.g., composed of the different materials). Typically, adjacent layers are composed of different compositions and/or have different thicknesses. Advantageously, the copper containing antimicrobial layers are found to have improved corrosion resistance and durability.

Each of the copper-containing antimicrobial layers independently can include copper metal (i.e., copper atoms in the zero oxidation state), copper oxides, copper nitrides, copper oxides containing carbon atoms, and combinations thereof. The incorporation of oxygen and/or carbon and/or nitrogen into copper layers improves corrosion and increases durability. In one refinement, each of the one or more copper-containing antimicrobial layers includes CuOₓ, where x is from 0.2 to 1.2. In another refinement, the one or more copper-containing antimicrobial layers can include CuOₐN_{b}, where a is from 0.0 to 1.2 and b, is from 0.01 to 0.4. In still another refinement, the one or more copper-containing antimicrobial layers can include CuO_{c}C_{d}, where c is from 0.0 to 1.2 and d, is from 0.01 to 0.4. In a variation, each copper-containing antimicrobial layers can independently include any combination of copper metal, CuOₓ, CuOaNb, and CuO_{c}C_{d}; Therefore, each copper-containing antimicrobial layer can independently include a combination of copper metal, CuOₓ, CuOaNb, and CuO_{c}C_{d} or a combination of copper metal and CuOₓ or a combination of copper metal and CuOaNb,; a mixture of copper metal and CuO_{c}C_{d} or a combination of copper metal, CuOₓ, and CuOaNb or a combination of copper metal, CuOₓ and CuO_{c}C_{d} or a combination of copper metal, CuOaNb, and CuO_{c}C_{d} or a combination of CuOₓ , CuOaNb, and CuO_{c}C_{d} or a combination of CuOₓ and CuOₐN_{b} or a combination of CuOₐN_{b}, and CuO_{c}C_{d} or a combination of CuOₓ, CuOₐN_{b}, and CuO_{c}C_{d}.

In a variation, the base layer includes zirconium or titanium, carbon and nitrogen where zirconium is present in an amount of at least 50 mole percent with each of the carbon and nitrogen present in an amount of at least 0.02 and 0.1 mole percent, respectively. In a refinement, the base layer includes a compound having the following formula:

M_{1-x-y}CₓN_{y}

where M is zirconium or titanium and x is 0.0 to 0.3 and Y is 0.1 to 0.5. In a refinement, x is 0.0 to 0.2 and y is 0.2 to 0.3. In another refinement, x is at least in increasing order of preference 0.0, 0.02, 0.03, 0.04, 0.05, 0.07, or 0.09 and at most in increasing order of preference, 0.5, 0.4, 0.3, 0.25, 0.2, 0.15, or 0.11. Similarly, in this refinement, y is at least in increasing order of preference 0.1, 0.15, 0.2, 0.25, 0.27, or 0.29 and at most in increasing order of preference, 0.6, 0.5, 0.40, 0.35, 0.33, or 0.31. In a further refinement, the base layer includes zirconium carbonitride described by Zr_{0.60}C_{0.10}N_{0.30}.

In a variation, the base layer includes zirconium or titanium, carbon, and oxygen where zirconium is present in an amount of at least 50 mole percent with each of the carbon and oxygen present in an amount of at least 0.02 and 0.1 mole percent, respectively. In a refinement, the base layer includes a compound having the following formula:

M_{1-x-y}OₓC_{y}.

where M is zirconium or titanium and x is 0.1 to 0.4 and y is 0.5 to 0.2. In a further refinement, the base layer includes zirconium oxycarbide described by Zr_{0.50}O_{0.35}C_{0.15}.

In another variation, the one or more copper-containing antimicrobial layers includes an atom selected from the group consisting of a metal other than copper, carbon, nitrogen, and combinations thereof. In a refinement, the one or more copper-containing antimicrobial layers include an atom selected from the group consisting of a transition metal other than copper, carbon, nitrogen, and combinations thereof. In still another refinement, the one or more copper-containing antimicrobial layers includes an atom selected from the group consisting of a zirconium, titanium, tin, and combinations thereof. Typically, the atom is present in an amount from about 1 mol percent to about 60 mole percent of the total moles of atoms in the one or more copper-containing antimicrobial layers. In a refinement, the atom is present in an amount of at least, in increasing order of preference, 0.1 mol percent, 0.5 mol percent, 1 mol percent, 3 mol percent, or 5 mol percent of the total moles of atoms in the one or more copper-containing antimicrobial layers. In another refinement, the atom is present in an amount of equal to or less than, in increasing order of preference, 70 mole percent, 60 mole percent, 50 mole percent, 40 mole percent, 30 mole percent, 20 mole percent, or 10 mole percent of the total moles of atoms in the one or more copper-containing antimicrobial layers.

The base substrate used herein can virtually include any solid substrate. Examples of such substrates include metal substrates, plastic substrates, and glass substrates. In one variation, the base substrate is not glass. In some variations, the base substrate is pre-coated with a metal adhesion layer. Such metal adhesion layers include metals such as chromium, nickel, tungsten, zirconium, and combinations thereof. Although any thickness for the adhesion layer can be used, useful thicknesses are from 100 nm to 0.2 microns.

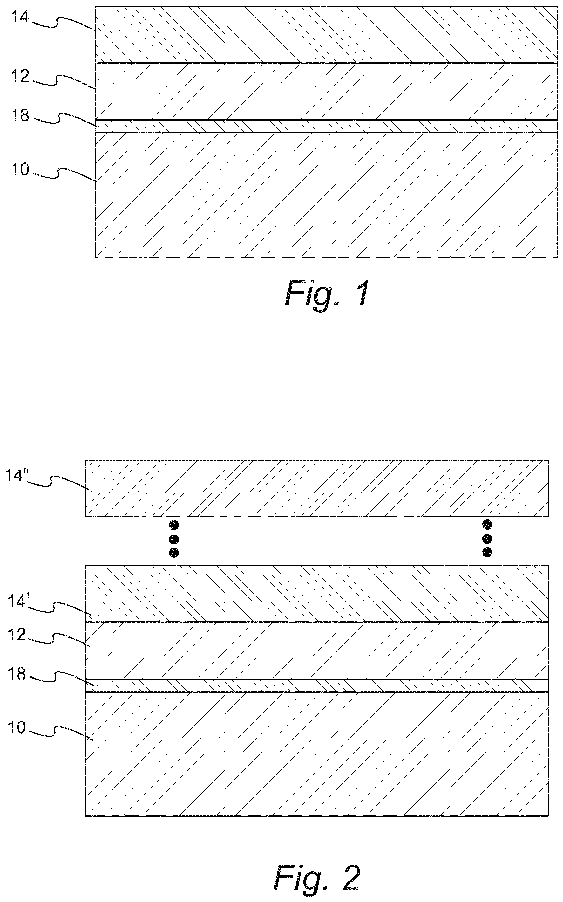

Figure 1 provides an example of a coated substrate that includes a single copper-containing antimicrobial layer. In this example, base substrate 10 is coated with base layer 12, which is overcoated with copper-containing antimicrobial layer 14. In a refinement, optional metal adhesion layer 18 is interposed between base substrate 10 and layer 12. In a refinement, the optional metal adhesion layer 18 contacts the base substrate 10. In another refinement, base layer 12 contacts the base substrate 10 or adhesion layer 18 if present. In another refinement, base layer 12 has a thickness from about 100 to 500 nm, copper-containing antimicrobial layer 14 has a thickness from about 50 to 1500 nm, and metal adhesion layer 18 when present, has a thickness from about 10 to 200 nm. In still another refinement, base layer 12 has a thickness from about 200 to 400 nm, copper-containing antimicrobial layer 14 has a thickness from about 100 to 300 nm, and metal adhesion layer 18 when present, has a thickness from about 20 to 80 nm.

Figure 2 provides an example of a coated substrate that includes a plurality of copper-containing antimicrobial layers. In a refinement, optional metal adhesion layer 18 is interposed between base substrate 10 and layer 12. In a refinement, the optional metal adhesion layer 18 contacts the base substrate 10. In another refinement, base layer 12 contacts the base substrate 10 or metal adhesion layer 18, if present. In this example, base substrate 10 is coated with base layer 12, which is overcoated with a first copper-containing antimicrobial layer 14^{l}. One or more additional copper-containing antimicrobial layers 14ⁱ are disposed over the first copper-containing antimicrobial layer 14^{l} up to the last copper-containing antimicrobial layer 14ⁿ where i is an integer layer for each layer and n is total number of copper-containing antimicrobial layers and the integer label for the last copper-containing antimicrobial layer. In a refinement, the first copper-containing antimicrobial layer 14^{l} (which is closest to the base substrate) contacts the base layer 12. Typically, coated substrate 10 includes 2 to 5 copper-containing antimicrobial layers (i.e., n is 2 to 5). In another refinement, base layer 12 has a thickness from about 100 to 800 nm, each copper-containing antimicrobial layer has a thickness from about 50 to 600 nm, and metal adhesion layer 18, when present, has a thickness from about 10 to 200 nm. In still another refinement, base layer 12 has a thickness from about 200 to 400 nm, each copper-containing antimicrobial layer has a thickness from about 100 to 300 nm, and metal adhesion layer 18, when present, has a thickness from about 20 to 80 nm.

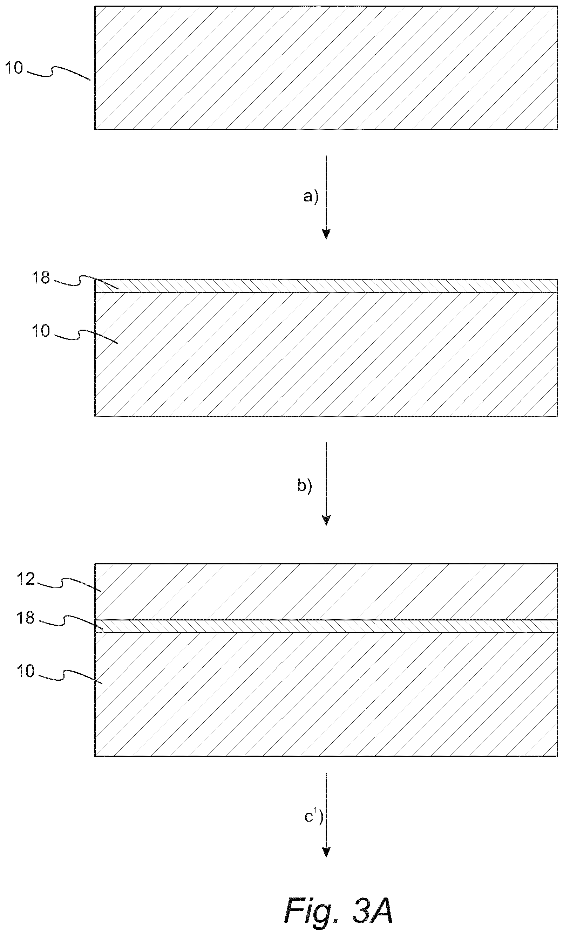

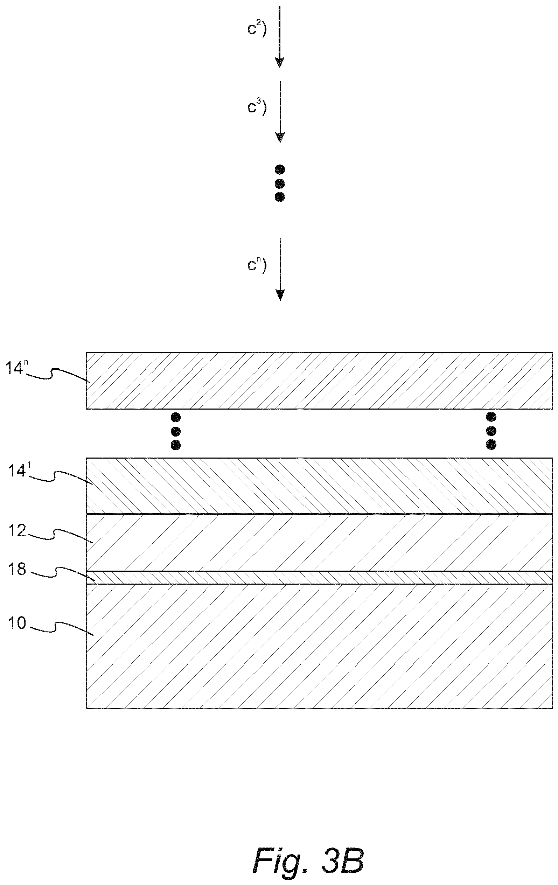

Another feature of the present invention is the ability to visually detect when the top copper-containing antimicrobial layer has worn. In this context, the top copper-containing antimicrobial layer is furthest from the base substrate and exposed to ambient. Advantageously, the coated substrate is such that the color of the top copper-containing antimicrobial layer has a visually perceivable color that is different from the color of the layer immediately below it. For a coated substrate having a single copper-containing antimicrobial layer, the layer immediately below is the base layer. When a plurality of copper-containing antimicrobial layers are present, the layer immediately below the top copper-containing antimicrobial layer is another copper-containing antimicrobial layer. The color of each of the base layer and copper-containing antimicrobial layers can independently be changed by adjusting the thicknesses and or stoichiometries of the layer. The top copper-containing antimicrobial layer and the layer immediately below the top copper-containing antimicrobial layer (as well as the substrate and other layers) can be characterized by Lab color space coordinates L*, a*, and b* relative to CIE standard illuminant D50. In a refinement, at least one of Lab color space coordinates L*, a*, and b* relative to CIE standard illuminant D50 of the top copper-containing antimicrobial layer differs from that of the layer immediately below the top copper-containing antimicrobial layer by at least in increasing order of preference, 5%, 10%, 15%, 20%, 25% or 50%. In another refinement, each of the Lab color space coordinates L*, a*, and b* relative to CIE standard illuminant D50 of the top copper-containing antimicrobial layer differ from those of the layer immediately below the top copper-containing antimicrobial layer by at least in increasing order of preference, 5%, 10%, 15%, 20%, 25% or 50%. Referring to Figure 3, a method for forming a coated substrate is provided. The method includes a step of providing a base substrate. In step a), base substrate 10 is optionally coated with metal adhesion layer 18. In step b), base substrate is coated with base layer 12. In a refinement, the base layer is composed of a component selected from the group consisting of zirconium carbonitrides, zirconium oxycarbides, titanium carbonitrides, titanium oxycarbides, diamond-like carbon, chromium nitride, chromium carbonitride, chromium metal, and combinations thereof. In steps c^{l}-cⁿ), one or more copper-containing antimicrobial layers are deposited over the base layer, each of the one or more copper-containing antimicrobial layers include copper atoms in a +1 oxidation state and/or a +2 oxidation state. In a refinement the base layer and the one or more copper-containing antimicrobial layers are independently deposited by a physical vapor deposition process. Examples of useful, physical vapor deposition processes include, but are not limited to, a cathodic arc deposition process, an electron-beam physical vapor deposition process, evaporation, a pulsed laser deposition process, or sputtering (e.g., HIPIMS).

Details for the base substrate, base layer, and the one or more one or more copper-containing antimicrobial layers are the same as set forth above. For example, one or more of each of the copper-containing antimicrobial layers independently includes a component selected from the group consisting of copper metal, copper oxides, copper nitrides, copper oxides containing carbon atoms, and combinations thereof. In a refinement as set forth above, the one or more copper-containing antimicrobial layers include an atom selected from the group consisting of a transition metal other than copper, carbon, nitrogen, and combinations thereof. In another refinement, as set forth above, the base layer has a thickness from about 100 to 500 nm, and each copper-containing antimicrobial layer has a thickness from about 50 to 3000 nm.

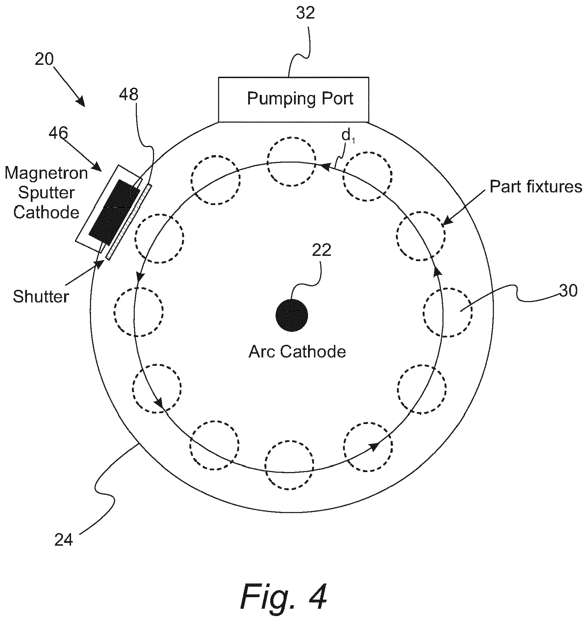

Each of the base layer and the copper-containing antimicrobial layers can be deposited by any number of thin film deposition techniques known in the coatings art. In particular, these layers can be deposited by PVD techniques. Examples of PVD techniques include, but are not limited to, cathodic arc deposition, electron-beam physical vapor deposition, evaporation, pulsed laser deposition, and sputtering. Figure 4 provides a schematic illustration of a deposition system that can be used to form the coated substrates as set forth above. Coating system 20 includes arc source 22 disposed within vacuum chamber 24. Arc source 22 is used to deposit the metal adhesion layer and the base layer and/or the copper-containing antimicrobial layers set forth above. Coating system 20 also includes magnetron sputter source 26 and associated shutter 28, which can alternatively be used for depositing the copper-containing antimicrobial layers. Shutter 28 controls the availability of magnetron sputter source 26, opening when a copper alloy layer is deposited and closed otherwise. Base substrate 30 is also disposed with vacuum chamber 24, typically moving about arc source 22 along direction d₁. Pump port 32 allows connection to a vacuum system that maintains a reduced pressure in vacuum chamber 24.

The following examples illustrate the various embodiments of the present invention. Those skilled in the art will recognize many variations that are within the spirit of the present invention and scope of the claims.

### Example 1 (CuNx coating)

A vacuum thin film deposition chamber is pumped down to a pressure of 8.0x10⁻⁵ Torr. Inside the chamber, stainless steel panels are mounted on a fixture near the wall and facing a centrally located cylindrical arc Copper cathode. An ion etch surface preparation is carried out by backfilling with Argon gas to a pressure of 25.0 mTorr and a bias voltage of -500V is applied to parts. This step lasts 5 minutes after which the Argon gas is shut off. The chamber is backfilled by Oxygen to a pressure of 1.0 mTorr and a substrate bias of -50V is applied. A Copper Oxide adhesion layer is applied to the panels by striking an arc on the arc cathode at a current of 350A. This step lasts 5 minutes to build a layer of 140nm thick Copper Oxide. A final coating layer comprised of a Copper Nitride is applied by continuing to run the arc on the Cu target but turning off the Oxygen and adding Nitrogen that flows at 125 sccm for a composition of approximately CuN_{0.20}. This layer is built up to 740nm in 20 minutes at which point the Copper arc cathode is turned off and the Nitrogen gas is shut off. The resulting film is a total of 880nm thick.

### Example 2 (Multilayer coating with a CuOx topcoat)

A vacuum thin film deposition chamber is pumped down to a pressure of 8.0x10⁻⁵ Torr. On a carousel inside the chamber, stainless steel panels are mounted on racks that rotate in a 2-axis planetary motion between two wall mounted magnetron sputtering cathodes. An ion etch surface preparation is carried out by backfilling with Argon gas to a pressure of 30.0 mTorr and a bias voltage of -300V for 0.5 min followed by -600V for 4min is applied to parts. A Zirconium metal adhesion layer is applied to the panels by powering Zirconium sputtering magnetron cathode to 10 kW. For this, the chamber is backfilled by Argon to a pressure of 3.0 mTorr and a substrate bias of -75V is applied. This step lasts 2 minutes to build a layer of 50nm thick Zr metal. A second coating layer comprised of a Zirconium Oxide, is applied by continuing to run sputter magnetron on the Zr target but adding Oxygen gas at flows of 50 sccm for a composition of approximately Zr0.60O0.40. This layer is built up to 30nm in 2 minutes at which point the Zr cathode is turned off. The Oxygen flow is turned up to 85 sccm and the Argon continues to flow to maintain a pressure of 3.0 mTorr. A voltage of 560V is applied to the sputtering magnetron Copper cathode for a duration of 10 minutes to result in a composition of approximately CuO0.82 with a layer thickness of 1130nm. The resulting film is a total of 1210nm thick.

### Example 3 (Multilayer coating with a CuZryOx topcoat)

A vacuum thin film deposition chamber is pumped down to a pressure of 8.0x10⁻⁵ Torr. On a carousel inside the chamber, stainless steel panels are mounted on racks that rotate in a 2-axis planetary motion between two wall mounted magnetron sputtering cathodes; both with shutters. One of the cathodes is Zirconium while the other cathode is an alloy of 50 at% Copper and 50 at% Zirconium. An ion etch surface preparation is carried out by backfilling with Argon gas to a pressure of 30.0 mTorr and a bias voltage of -500V for 5min is applied to parts. A Zirconium metal adhesion layer is applied to the panels by powering the Zirconium sputtering magnetron cathode to 15 kW and opening the shutter. For this, the chamber is backfilled by Argon to a pressure of 3.0 mTorr and a substrate bias of -75V is applied. This step lasts 2 minutes to build a layer of 100nm thick Zr metal on the panels. A second coating layer comprised of a Zirconium Nitride is applied by continuing to run the sputter magnetron on the Zirconium cathode but adding a flow of Nitrogen gas for a layer composition of approximately ZrN. During this and the subsequent step, the total flow maintains a pressure of 3.0mTorr. This layer is built up to 30nm over a duration of 1 minute. The Zirconium cathode is then powered off and the shutter is closed. The shutter for the alloy cathode is then opened. The alloy cathode is powered to 6kW for duration of 4 minutes to result in a composition of approximately CuZr_{0.6}O_{2.4} with a layer thickness of 490nm. The resulting film is a total of 620nm thick.

Table 1 provides the physical properties of copper samples as well as the atomic percentages of copper, oxygen, nitrogen, and zirconium in the samples. Table 1 also provides color properties of the samples.

**Table 1. Physical properties of copper samples**

| **Example#** | **Coating** | **Process** | **Efficacy** | **Composition (at%)** | | | | **Color (CIELAB D65)** | | |
|---|---|---|---|---|---|---|---|---|---|---|
| | | | **(LOG counts*)** | **Cu** | **O** | **N** | **Zr** | **L*** | **a*** | **b*** |
| 1 | CuNₓ | Cathodic Arc | 4.38 | 70 | 10 | 20 | - | 59.85 | - 1.10 | 7.13 |
| 2 | CuOₓ | Sputtering | 5.76 | 55 | 45 | - | - | 51.66 | 0.41 | 4.00 |
| 3 | CuZr_{y}Oₓ | Sputtering | 6.40 | 25 | 60 | - | 15 | 52.52 | 5.70 | 6.58 |

While exemplary embodiments are described above, it is not intended that these embodiments describe all possible forms of the invention. Rather, the words used in the specification are words of description rather than limitation, and it is understood that various changes may be made without departing from the spirit and scope of the invention. Additionally, the features of various implementing embodiments may be combined to form further embodiments of the invention.

## Claims

1. A coated substrate comprising:
a base substrate;
a base layer disposed over the base substrate, the base layer composed of a component selected from the group consisting of zirconium carbonitrides, zirconium oxycarbides, titanium carbonitrides, titanium oxycarbides, diamond-like carbon, chromium nitride, chromium carbonitride, chromium metal, and combinations thereof; and
one or more copper-containing antimicrobial layers disposed over the base layer, each of the one or more copper-containing antimicrobial layers includes copper atoms in a +1 oxidation state and/or a +2 oxidation state.

2. The coated substrate of claim 1, wherein each of the one or more copper-containing antimicrobial layers independently includes:
a component selected from the group consisting of copper metal, copper oxides, copper nitrides, copper oxides containing carbon atoms, and combinations thereof; or
copper atoms in a zero oxidation state.

3. The coated substrate of claim 1, wherein the one or more copper-containing antimicrobial layers include:
(i) CuOₓ, where x is from 0.2 to 1.2; or
(ii) CuOₐN_{b}, where a is from 0.0 to 1.2 and b, is from 0.01 to 0.4; or
(iii) CuO_{c}C_{d}, where c is from 0.0 to 1.2 and d, is from 0.01 to 0.4; or
(iv) an atom selected from the group consisting of a transition metal other than copper, carbon, nitrogen, and combinations thereof; or
(v) 2 to 5 copper-containing antimicrobial layers.

4. The coated substrate of claim 1, wherein the one or more copper-containing antimicrobial layers include an atom selected from the group consisting of a zirconium, titanium, tin, and combinations thereof.

5. The coated substrate of claim 4, wherein the atom is present in an amount from about 5 mol percent to about 60 mole percent of the total moles of atoms in the one or more copper-containing antimicrobial layers.

6. The coated substrate of claim 1, wherein the base layer includes:
(i) zirconium or titanium in an amount of at least 50 mole percent carbon in an amount of at least 0.02 mole percent, and nitrogen in an amount of at least 0.02 mole percent; or
(ii) a compound having formula: M_{1-x-y}CₓN_{y}., where M is zirconium or titanium and x is 0.0 to 0.3 and Y is 0.1 to 0.5; or
(iii) a compound having formula: M_{1-x-y}CₓN_{y}, where M is zirconium or titanium and x is 0.0 to 0.2 and Y is 0.2 to 0.3; or
(iv) zirconium carbonitride having formula Zr_{0.60}C_{0.10}N_{0.30}; or
(v) a compound having formula: M_{1-x-y}OₓC_{y}, where M is zirconium or titanium and x is 0.1 to 0.4 and Y is 0.5 to 0.2; or
(vi) zirconium oxycarbide having formula Zr_{0.50}O_{0.35}C_{0.15}.

7. The coated substrate of claim 1, wherein a single copper-containing antimicrobial layer is disposed over the base layer.

8. The coated substrate of claim 1, wherein the base layer has a thickness from about 100 to 500 nm, and each copper-containing antimicrobial layer has a thickness from about 50 to 3000 nm.

9. The coated substrate of claim 1, further comprising a metal adhesion layer interposed between the base substrate and the base layer.

10. The coated substrate of claim 1, wherein a top copper-containing antimicrobial layer has a visually perceivable color that is different from the color of the layer immediately below it.

11. The coated substrate of claim 10, wherein at least one of Lab color space coordinates L*, a*, and b* relative to CIE standard illuminant D50 of the top copper-containing antimicrobial layer differs from that of the layer immediately below the top copper-containing antimicrobial layer by at least 5%.

12. A method for forming a coated substrate, the method comprising:
providing a base substrate;
depositing a base layer over the base substrate, the base layer composed of a component selected from the group consisting of zirconium carbonitrides, zirconium oxycarbides, titanium carbonitrides, titanium oxycarbides, diamond-like carbon, chromium nitride, chromium carbonitride, chromium metal, and combinations thereof; and
depositing one or more copper-containing antimicrobial layers over the base layer, each of the one or more copper-containing antimicrobial layers includes copper atoms in a +1 oxidation state and/or a +2 oxidation state.

13. The method of claim 12, wherein the one or more copper-containing antimicrobial layers are deposited by a physical vapor deposition process; wherein the physical vapor deposition process is a cathodic arc deposition process, an electron-beam physical vapor deposition process, evaporation, a pulsed laser deposition process, or sputtering.

14. The method of claim 12, wherein:
(i) each of the copper-containing antimicrobial layers independently includes a component selected from the group consisting of copper metal, copper oxides, copper nitrides, copper oxides containing carbon atoms, and combinations thereof; or
(ii) the one or more copper-containing antimicrobial layers includes an atom selected from the group consisting of a transition metal other than copper, carbon, nitrogen, and combinations thereof.

15. The method of claim 12, wherein the base layer has a thickness from about 100 to 500 nm, and each copper-containing antimicrobial layer has a thickness from about 50 to 3000 nm.
